# EUROPEAN PATENT SPECIFICATION

(11) **EP 2 764 563 B1**
(45) Date of publication and mention of the grant of the patent: **21.09.2016**
(21) Application number: 12772390.6
(22) Date of filing: 05.10.2012
(51) Int. Cl.: H01M 4/04, H01L 31/18, B44C 1/22, H01M 4/02, H01M 4/70, H01M 4/38, H01M 4/66, C01B 33/02, H01M 4/1395, H01L 21/306, H01M 10/052

(54) **ETCHED SILICON STRUCTURES, METHOD OF FORMING ETCHED SILICON STRUCTURES AND USES THEREOF**
GEÄTZTE SILICIUMSTRUKTUREN, VERFAHREN ZUR HERSTELLUNG VON GEÄTZTEN SILICIUMSTRUKTUREN UND IHRE VERWENDUNG
STRUCTURES GRAVÉES EN SILICIUM, PROCÉDÉ DE FORMATION DE STRUCTURES GRAVÉES EN SILICIUM ET LEURS UTILISATIONS

(30) Priority: 06.10.2011 GB 201117279
(43) Date of publication of application: 13.08.2014
(73) Proprietor: Nexeon Limited, Abingdon, Oxfordshire OX14 4SB (GB)
(72) Inventor: LIU, Fengming, Lower Earley Reading RG6 3DX (GB)
(74) Representative: Gilani, Anwar
(86) International application number: PCT/GB2012/052483
(87) International publication number: WO 2013/050785

(56) References cited:
- EP-A1- 2 051 317
- EP-A1- 2 226 374
- WO-A1-2007/083152
- WO-A1-2010/040985
- WO-A2-2009/010758
- WO-A2-2011/124893
- JP-A- H09 223 670
- US-A1- 2010 112 451
- US-A1- 2010 301 276
- US-A1- 2012 178 204
- PENG K ET AL: "Uniform, axial-orientation of one dimensional single-crystal silicon nanostructure arrays", ANGEWANDTE CHEMIE. INTERNATIONAL EDITION, WILEY VCH VERLAG, WEINHEIM, vol. 44, 1 January 2005 (2005-01-01), pages 2737-2742, XP002431331, ISSN: 1433-7851, DOI: 10.1002/ANIE.200462995
- QIU T ET AL: "Self-assembled growth and optical emission of silver-capped silicon nanowires", APPLIED PHYSICS LETTERS, AIP, AMERICAN INSTITUTE OF PHYSICS, MELVILLE, NY, US, vol. 84, no. 19, 10 May 2004 (2004-05-10), pages 3867-3869, XP012061406, ISSN: 0003-6951, DOI: 10.1063/1.1753063

## Description

### Field of the Invention

The present invention relates to a method of etching silicon.

### Background of the Invention

Rechargeable lithium-ion batteries are extensively used in portable electronic devices such as mobile telephones and laptops, and are finding increasing application in electric or hybrid electric vehicles. However, there is an ongoing need to provide batteries that store more energy per unit mass and / or per unit volume.

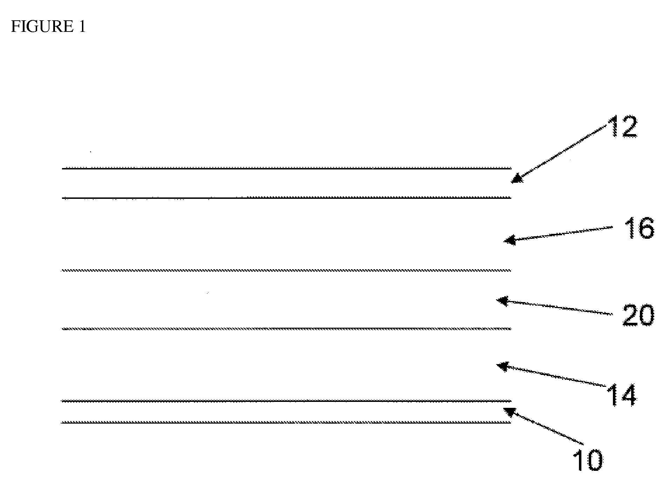

The structure of a conventional lithium-ion rechargeable battery cell is shown in Fig. 1. The battery cell includes a single cell but may also include more than one cell. Batteries of other metal ions are also known, for example sodium ion and magnesium ion batteries, and have essentially the same cell structure.

The battery cell comprises a current collector for the anode 10, for example copper, and a current collector for the cathode 12, for example aluminium, which are both externally connectable to a load or to a recharging source as appropriate. A composite anode layer 14 overlays the current collector 10 and a lithium containing metal oxide-based composite cathode layer 16 overlays the current collector 12 (for the avoidance of any doubt, the terms "anode" and "cathode" as used herein are used in the sense that the battery is placed across a load - in this sense the negative electrode is referred to as the anode and the positive electrode is referred to as the cathode).

The cathode comprises a material capable of releasing and reabsorbing lithium ions for example a lithium-based metal oxide or phosphate, LiCoO₂, LiNi_{0.8}Co_{0.15}Al_{0.05}O₂, LiMnₓNiₓCo₁₋₂ₓO₂ or LiFePO₄.

A porous plastic spacer or separator 20 is provided between the graphite-based composite anode layer 14 and the lithium containing metal oxide-based composite cathode layer 16. A liquid electrolyte material is dispersed within the porous plastic spacer or separator 20, the composite anode layer 14 and the composite cathode layer 16. In some cases, the porous plastic spacer or separator 20 may be replaced by a polymer electrolyte material and in such cases the polymer electrolyte material is present within both the composite anode layer 14 and the composite cathode layer 16. The polymer electrolyte material can be a solid polymer electrolyte or a gel-type polymer electrolyte and can incorporate a separator.

When the battery cell is fully charged, lithium has been transported from the lithium containing metal oxide cathode layer 16 via the electrolyte into the anode layer 14. In the case of a graphite-based anode layer, the lithium reacts with the graphite to create the compound, LiC₆. The graphite, being the electrochemically active material in the composite anode layer, has a maximum capacity of 372 mAh/g. ("active material" or "electroactive material" as used herein means a material which is able to insert into its structure, and release therefrom, metal ions such as lithium, sodium, potassium, calcium or magnesium during the respective charging phase and discharging phase of a battery. Preferably the material is able to insert and release lithium.)

The use of a silicon-based active anode material is also known in the art. Silicon has a substantially higher maximum capacity than graphite. However, unlike active graphite which remains substantially unchanged during insertion and release of metal ions, the process of insertion of metal ions into silicon results in substantial structural changes, accompanied by substantial expansion. For example, insertion of lithium ions into silicon results in formation of a Si-Li alloy. The effect of Li ion insertion on the anode material is described in, for example, "Insertion Electrode Materials for Rechargeable Lithium Batteries", Winter et al, Adv. Mater. 1988, 10, No. 10, pages 725-763.

US 7402829 discloses etching of a silicon substrate to form an array of silicon pillars extending from the silicon substrate.

Peng et al, "Dendrite-Assisted Growth of Silicon Nanowires in Electroless Metal Deposition", Adv. Funct. Mater. 2003, 13(2), 127-132 discloses that electroless deposition of Pt and Cu in HF solutions tends to result in formation of continuous grain films on silicon that result in uniform etching of the underlying silicon whereas silver forms nanoclusters that may be etched to form nanowires.

WO2009/010758 discloses the etching of silicon powder in order to make silicon material for use in lithium ion batteries. The resulting etched particles contain pillars on their surface.

US 2010/0301276 discloses a method of preparing a porous silicon nanorod structure by adding silicon to a solution of aqueous hydrogen fluoride and a metal precursor.

US 2008/0268652 discloses a method of forming porous silicon by putting silicon in contact with a solution of hydrofluoric acid, an alcohol and a metallic salt. Copper, silver, platinum and gold salts are disclosed. The pores have a depth lying in the range 150 - 250 nm and a diameter lying in the range 15 - 30 nm.

WO2011073666 discloses a method of making mesoporous particulate silicon using an aqueous chemical etchant comprising hydrofluoric acid and a dissolved metal salt.

US6399177 discloses a composite structure comprising a porous silicon-based film comprising a plurality of amorphous or polycrystalline rod-like elements extending from a substrate, made using high density plasma deposition.

US7402829 discloses an energy storage device comprising an anode comprising an array of sub-micron silicon structures supported on a silicon substrate, made by etching the silicon substrate.

WO2007083152 discloses a method of etching a silicon substrate comprising contacting the silicon substrate with an aqueous solution of a fluoride acid or a fluoride salt, a metal salt capable of electroless deposition of the metal on the silicon in the presence of fluoride ions and an alcohol.

US 2011/215441 discloses etching a silicon substrate under metal nanostructures on the silicon substrate; side-etching the silicon; and removing the metal nanostructures. Huang et al, "Metal-Assisted Chemical Etching of Silicon: A Review", Advanced Materials 2010, 1-24, discloses that electroless deposition of Pt and Cu tends to result in formation of a dense metal film that cannot be used to etch Si into wires or pores. Huang et al, "Metal-assisted electrochemical etching of silicon", Nanotechnology 21 (2010), 465301 discloses use of Ag and Cu in electrochemical etching of Si.

WO 2010/040985 discloses a process for etching silicon to form pillars on the etched surface using an etching solution comprising HF, silver ions and nitrate ions.

EP 2226374 discloses an etching composition for silicon materials, the composition comprising an organic oxidant dissolved in a solvent and a HF or HFB₄ de-oxidant.

EP 2051317 discloses growth of columnar bodies of silicon on a foil.

US 2010/112451 discloses formation of a plurality of active material bodies on a surface of a current collector by vapour deposition.

Ang. Chem. Int. Ed. 44, 2737 (2005) discloses production of silicon nanostructure arrays. Qui et al, Appl. Phys. Lett. 84, 3867 (2004) discloses structured silver capped silicon nanowires.

It is an object of the invention to provide a controllable method for etching silicon, in particular anisotropic etching of silicon.

It is a yet further object of the invention to provide a low-cost method for etching silicon.

### Summary of the Invention

The invention provides a method of etching silicon, the method comprising the steps of: partially covering at least one silicon surface of a material to be etched with a plurality of isolated islands of copper metal by an electroless deposition process comprising exposing the at least one surface of the material to be etched to an aqueous deposition composition comprising a copper salt and a source of fluoride ions; and exposing the at least one surface to an aqueous etching composition comprising an oxidant selected from the acid or salt of NO₃⁻ or NO₂⁻ and a source of fluoride ions wherein a bias is not applied to the silicon during etching of the material to be etched, wherein the aqueous etching composition is formed by adding the oxidant and, optionally, further fluoride ions to the aqueous deposition composition in aqueous form, and wherein the concentration of copper ions is diluted by addition of the aqueous oxidant and optional further fluoride to substantially stop further electroless deposition of copper once the electrolessly deposited copper has formed the plurality of isolated islands of copper; or wherein the material to be etched is removed from the aqueous deposition composition following formation of the plurality of isolated islands of copper metal and before being exposed to the aqueous etching composition.

The material to be etched may consist essentially of silicon and may be, for example, undoped, n-doped or p-doped silicon, or it may be a material containing silicon and one or more further materials, for example a material having at least one silicon surface, such as a material having a non-silicon core and a silicon shell.

Optionally, the oxidant is selected from the group consisting of alkali metal nitrates, ammonium nitrate and mixtures thereof.

Optionally, the aqueous etching composition is substantially free of copper ions. Optionally, the aqueous etching composition is formed by adding the oxidant and, optionally, further fluoride ions to the aqueous deposition composition.

The isolated islands optionally have a diameter in the range of 50-200 nm,
optionally 50-100 nm.

The isolated islands optionally have a diameter in the range of 50-200
nm.

Optionally, the at least one surface is etched to form silicon pillars extending from an etched silicon surface formed by etching of the at least one surface. Optionally, the method comprises the further step of detaching the silicon pillars from the etched silicon surface.

Optionally, the source of fluoride ions in the aqueous etching composition is hydrogen fluoride.

Optionally, the source of fluoride ions in the aqueous deposition composition is hydrogen fluoride.

Optionally, the concentration of hydrogen fluoride in the aqueous deposition composition and in the aqueous etching composition is independently in the range of 1 to 10 M.

Optionally, the concentration of the copper salt in the aqueous deposition composition is in the range of 0.001 to 5 M.

Optionally, the aqueous etching composition is substantially free of alcohols.

Optionally, the at least one surface is exposed to the aqueous deposition composition for less than 2 minutes, optionally no more than 1 minute.

Optionally, the silicon has a resistivity of at least 0.005 Ω.cm, optionally at least 0.01 Ω.cm.

Optionally, the silicon is n-doped, p-doped or a mixture thereof.

Optionally, the at least one surface has a {111} or {100} orientation. Optionally, the at least one surface has a (111) or (100) orientation.

Optionally, the method is conducted at a temperature of 0°C to 30°C, optionally about 20°C.

Optionally, the at least one surface of the material to be etched is etched to a depth of at least 0.5 microns.

Optionally, the etched silicon comprises pores extending into at least one etched surface formed by etching the at least one surface.

Optionally, the pores have a diameter of at least 50 nm.

Optionally, the etched silicon comprises pillars extending out from at least one etched surface formed by etching the at least one surface.

Optionally, the pillars have a length of at least 0.5 microns.

Optionally, the material to be etched is in the form of bulk silicon, optionally a silicon wafer. Optionally, the method comprises the step of breaking the etched bulk silicon into a plurality of etched bulk silicon fragments.

Optionally, the silicon is in the form of a silicon powder.

### Description of the Drawings

The invention will now be described in more detail with reference to the Figures, in which:
Figure 1 illustrates schematically a lithium ion battery;
Figure 2A illustrates schematically an etching process according to an embodiment of the invention;
Figure 2B illustrates schematically a first etched silicon product that may be formed by the process of Figure 2A;
Figure 2C illustrates schematically a second etched silicon product that may be formed by the process of Figure 2A;
Figure 3 is a scanning electron microscope (SEM) image of an upper surface of an etched silicon wafer formed by a method according to an embodiment of the invention;
Figure 4A is a SEM image of an upper surface of an etched silicon wafer formed by a method according to an embodiment of the invention;
Figure 4B is a SEM image of the etched silicon wafer of Figure 4A viewed at an angle of 75°;
Figure 5A is a SEM image of an upper surface of an etched silicon wafer formed by a method according to an embodiment of the invention;
Figure 5B is a SEM image of the etched silicon wafer of Figure 5A viewed at an angle of 75°;
Figure 6A is a SEM image of an upper surface of an etched silicon wafer formed by a method according to an embodiment of the invention;
Figure 6B is a SEM image of the etched silicon wafer of Figure 6A viewed at an angle of 75°;
Figure 7A is a SEM image of an upper surface of an etched silicon wafer formed by a method according to an embodiment of the invention;
Figure 7B is a SEM image of the etched silicon wafer of Figure 7A viewed at an angle of 75°;
Figure 8 is a SEM image of an upper surface of a silicon wafer carrying electrolessly deposited copper formed by a method according to an embodiment of the invention;
Figure 9 is a SEM image of an upper surface of a silicon wafer carrying electrolessly deposited copper formed by another method according to an embodiment of the invention;
Figure 10A is a SEM image of an upper surface of an etched silicon wafer formed by a method according to an embodiment of the invention;
Figure 10B is a higher magnification of the SEM image of Figure 10A;
Figure 11A is a SEM image of an upper surface of an etched silicon wafer formed by a method according to an embodiment of the invention;
Figure 11B is a SEM image of the etched silicon wafer of Figure 11A viewed at an angle of 75°;
Figure 12A is a SEM image of an upper surface of an etched silicon wafer formed by a method according to an embodiment of the invention;
Figure 12B is a SEM image of the etched silicon wafer of Figure 12A viewed at an angle of 75°;
Figure 13A is a SEM image of an upper surface of an etched silicon wafer formed by a method according to an embodiment of the invention;
Figure 13B is a SEM image of the etched silicon wafer of Figure 13A viewed at an angle of 75°;
Figure 14A is a SEM image of an upper surface of an etched silicon wafer formed by a method according to an embodiment of the invention;
Figure 14B is a SEM image of the etched silicon wafer of Figure 14A viewed at an angle of 75°;
Figure 15A is a SEM image of an upper surface of an etched silicon wafer formed by a method according to an embodiment of the invention;
Figure 15B is a SEM image of the etched silicon wafer of Figure 15A viewed at an angle of 75°;
Figure 16A is a SEM image of an etched silicon wafer formed by a method according to an embodiment of the invention;
Figure 16B is a higher magnification of the SEM of Figure 16A;
Figure 17 is a SEM image of an etched silicon wafer formed by a method according to an embodiment of the invention;
Figure 18A is a SEM image of a thin silicon wafer carrying pillars formed by a method according to an embodiment of the invention;
Figure 18B is a magnified version of Figure 18A;
Figure 18C is a SEM image of fragments formed by breaking the wafer of Figures 18A and 18B;
Figure 18D is a magnified SEM image of a fragment of Figure 18C showing pillars extending from the fragment surface;
Figure 19A is a SEM image of silicon fibres harvested by scraping the surface of an etched silicon wafer carrying silicon pillars;
Figure 19B is a SEM image of silicon fibres of Figure 19A showing an end-on view of the harvested silicon fibres; and
Figure 20 is a SEM image of a surface of an etched silicon particle of an etched silicon powder formed by a method according to an embodiment of the invention.

### Detailed Description of the Invention

The process of etching silicon with copper involves a deposition stage in which elemental copper is deposited on a surface of the silicon to cover some but not all of the surface to be etched, and an etching stage in which silicon underlying the deposited copper is etched.

Copper may be deposited on the surface of the silicon by any process known to the skilled person including thermal evaporation, sputtering, electrodeposition and electroless deposition.

If copper is deposited by thermal evaporation, electrodeposition or sputtering then it may be deposited through or over one or more removable masks or templates to define a regular or irregular copper pattern on the surface of the silicon. Exemplary methods of applying a metal using a template are described in Huang et al, "Metal-Assisted Chemical Etching of Silicon: A Review", Advanced Materials 2010, 1-24. Methods such as these may allow more precise control over the size, spacing and arrangement of the resulting silicon structures formed by etching compared to electroless deposition. A suitable removable template can for example be provided by an arrangement of nanospheres or nanoparticles (e.g. SiO₂ nanospheres) or by a patterned anodised aluminium film.

Electroless deposition may produce a random, scattered distribution of copper ions on the silicon surface and may be a cheaper deposition step compared to the other methods listed above.

If copper is deposited by an electroless process then in a first stage silicon is treated with an aqueous solution of hydrogen fluoride and a source of Cu²⁺ ions. The HF reacts with the silicon according to the following half-reaction:

Si⁰ + 6F⁻ → SiF₆²⁻ + 4e⁻

Electrons generated in etching of silicon cause reduction of aqueous copper ions to elemental copper according to the following half-reaction:

2Cu²⁺ (aq) + 4e⁻ → 2Cu (s)

Elemental copper formed by this process is deposited on the surface of the silicon.

The aqueous solution may contain one or more solvents in addition to water, for example water-miscible organic solvents. In a preferred embodiment, the aqueous etching solution is substantially free of other solvents.

Any water-soluble copper salt may be used as the source of copper ions including, without limitation, copper sulphate and copper nitrate. The copper ions may be provided in a concentration range of about 1mM - 5 M, optionally in the range of 10 mM - 1 M, 10-200 mM or 0.1 - 1 M.

During electroless elemental copper formation, it is the copper ions that are reduced by electrons generated in the etching process. It will be appreciated that electroless deposition of copper as described herein will result in some degree of etching at the silicon surface, unlike copper deposition by thermal evaporation or sputtering, and so the deposition stage may include some degree of silicon etching.

In the case of thermally evaporated or sputtered copper, the thickness of copper deposited may be controlled by control of the deposition rate and the percentage coverage of the silicon surface may be controlled by the dimensions of the mask or template structure.

In the case of electroless deposition of copper, the extent of copper formation may be controlled by the concentration of copper ions in the solution, and / or the length of time that the silicon remains in the solution.

Once copper has been deposited on the silicon surface, etching (or further etching in the case of electrolessly deposited copper) may take place in an etching stage in the presence of HF and an oxidant.

The oxidant (or oxidising agent) is a material that gains electrons or transfers oxygen atoms in a chemical redox reaction. The oxidant is preferably one that is less reactive (a weaker oxidant) than hydrogen peroxide. Preferably the oxidant has an oxidation potential with respect to hydrogen less than that of hydrogen peroxide, i.e. less than 1.2 V. The oxidant may be selected from the group consisting of O₂; O₃; fluorine; chlorine; iodine; bromine; chlorine trifluoride; dinitrogen trioxide; metal oxides; propyl nitrate; and the acid or a salt of BrO₃⁻ NO₃⁻, S₂O₈²⁻, NO₂⁻, B₄O₇²⁻, ClO₂⁻, ClO₃⁻ or ClO₄⁻ or a mixture thereof. Exemplary salts include ammonium perchlorate, ammonium permanganate, calcium chlorate; calcium hypochlorite; chromium trioxide (chromic anhydride); potassium bromate; potassium chlorate; sodium chlorate; sodium chlorite; and sodium perchlorate. Exemplary acids include chromic acid and perchloric acid. Alkali metal nitrates and ammonium nitrate are preferred.

The oxidant may be provided in a concentration of at least about 0.001 M, optionally at least about 0.01 M, optionally at least about 0.1 M in an aqueous etching solution. The oxidant may be provided in a concentration of up to about 1 M. Preferably, the aqueous etching solution is substantially free of copper ions.

The aqueous etching solution may contain one or more solvents in addition to water, for example water-miscible organic solvents. In a preferred embodiment, the aqueous etching solution is substantially free of other solvents.

HF may be provided in a concentration of at least 0.1 M, optionally about 1-10 M. The same concentration range may be provided for the deposition stage in the case of electroless deposition.

The concentration of HF in the etching stage (and in the deposition stage in the case of electroless deposition), and / or the concentration of the oxidant in the etching stage, may be monitored during the deposition and / or etching process and adjusted as required.

The silicon may be irradiated during the deposition and etching steps. The intensity and wavelength of the light used will depend on the nature of the silicon being etched. The reaction material may be irradiated with a light source having a wavelength in the region of the bandgap of the silicon material being etched. The use of visible light is preferred. The light source may be ambient light; a lamp; or ambient light augmented by light emitted from a lamp.

The etching process may be carried out in any suitable reaction vessel, for example a vessel formed from a HF-resistant material, such as polyethylene or polypropylene or a reaction vessel lined with a HF resistant material such as a HF resistant rubber. If the silicon is irradiated then the vessel may be light-transmissive. Electroless deposition may likewise be carried out in such a reaction vessel.

In the case of electroless deposition, the deposition and etching stages may take place in a single reaction vessel in which an aqueous solution containing the oxidant(s), and optionally further fluoride, is added to the reaction vessel following formation of elemental copper. The concentration of copper ions may be diluted by addition of the oxidant solution. This may make further deposition of copper less probable than a competing process of etching of silicon by HF and the oxidant.

In another embodiment, the silicon is removed from the aqueous solution comprising copper ions once a desired level of copper has formed on the surface of the silicon, and the etching stage takes place in a separate aqueous solution containing a fluoride source, such as HF, and the oxidant(s), wherein the separate aqueous solution is substantially free of copper ions.

Etching may take place by a non-electrochemical process, i.e. a bias voltage is not applied to the silicon during etching.

Anisotropic etching may form structured silicon, in particular silicon carrying pillars or porous, preferably macroporous, silicon.

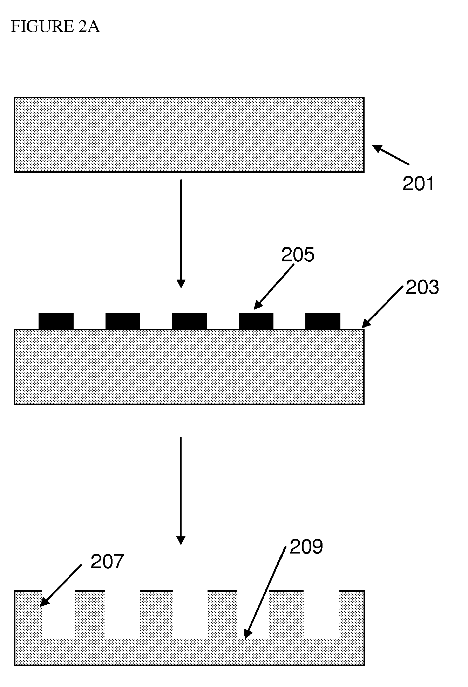

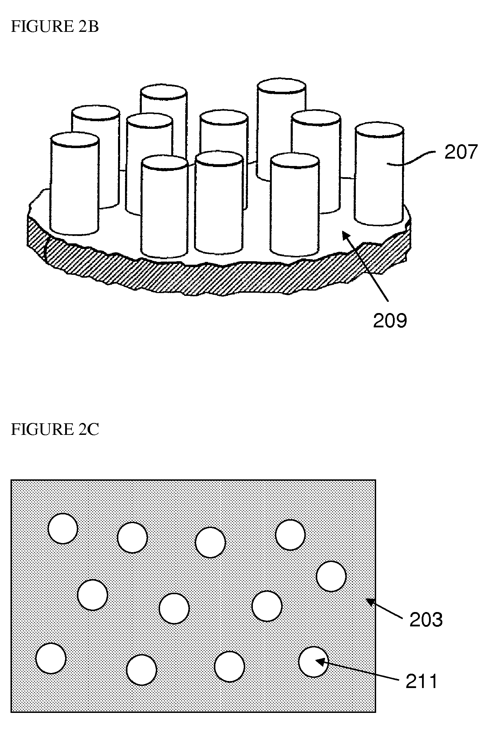

An exemplary etching process is illustrated in Figures 2A and 2B, which are not drawn to any scale. With reference to Figure 2A, in a first stage elemental copper 205 is formed on the surface 203 of silicon wafer 201. In a second stage, the area underneath the deposited copper is etched in the presence of the oxidant and HF to form pillars 207 in the surface of the silicon.

Although the invention is illustrated herein with reference to a silicon wafer, it will be appreciated that any substrate having a silicon surface may be used including, without limitation, non-wafer silicon sheets, silicon ribbons and particles of silicon such as silicon flakes and spherical or spheroid silicon particles.

Pillars 209 may have any shape. For example, pillars may be branched or unbranched; substantially straight or bent; and of a substantially constant thickness or tapering.

With reference to Figure 2B, the pillars 207 extending outwardly from, and may be spaced apart on, etched surface 209. The pillars may be wires, nanowires, rods and columns. The pillars may be detached from the etched surface 209 to form silicon fibres. In one arrangement, substantially all pillars 207 may be spaced apart. In another arrangement, some of the pillars 207 may be clustered together.

The cross-sections of the pillars may form regular shapes (e.g. circular, square or triangular) or be irregular in shape (e.g. may contain one or more concave or convex curved sides or branches or spurs extending outwards or combinations thereof). Since the shape of the pillars is partly determined by the shape of the exposed surface areas of silicon after copper deposition, it can be understood that methods comprising electroless copper deposition may tend to produce pillars with irregular shaped cross sections.

Figure 2C illustrates etched silicon comprising pores 211 extending into the silicon formed by etching surface 203 to produce macroporous silicon (i.e. silicon with pores of diameter > 50nm). The process of etching silicon may be substantially the same as illustrated in Figure 2A, except that the copper is deposited such that etching results in formation of pores 211 on the surface 203 of the silicon to be etched and extending downwards into the silicon material, rather than pillars 207 extending from an etched surface 209 of the etched silicon. In contrast to structured silicon having pillars, macroporous silicon may have a substantially continuous connected network of silicon walls at the outer surface of the silicon that has been etched.

The surface of the etched silicon may comprise both regions of porous silicon and regions with pillars. The etched silicon may also combine regions of porous and pillared silicon in an inward extending direction. That is, an outer shell region of the etched silicon may comprise pillared silicon whilst the inner region comprises porous silicon and vice versa.

The extent of copper deposition on the surface of the silicon in the first stage may be controlled by controlling one or more of the length of time that the silicon is exposed to the solution containing copper ions; the concentration of copper ions in the solution; and the number of moles of copper per unit surface area of silicon exposed to the copper-containing solution.

Pores may extend at least 0.5 microns into the silicon from silicon surface 203, optionally at least 1 micron, optionally at least 2 microns. The pores may have a diameter of at least 100 nm, optionally at least 300nm, optionally at least 0.5 microns. The pores may extend inwards perpendicular to the silicon surface or may extend inwards at any intermediate angle. Not all pores may extend in the same direction, instead the plurality of pores may extend in a plurality of directions. The direction in which the pores extend inwards may change partway down. Two or more pores may join to form an irregular network of pores below the surface of the silicon.

After a substrate has been etched to form pillars and / or porous silicon, the etched surface or surfaces may be treated to detach the pillars and / or form porous silicon fragments. Exemplary treatments include mechanical treatments, for example scraping the etched surface, and ultrasonic treatment. In this embodiment, an etched silicon sheet or wafer preferably has a thickness of around 5 to 200 µm.

It will be appreciated that detached pillars may have the same shape and dimensions as pillars described above. The detached silicon may include porous silicon fragments, discrete detached silicon pillars and silicon pillar clumps.

Figures 2A-2C illustrate etching of only one surface of a silicon starting material, however it will be appreciated that more than one surface of a starting material may be etched. For example, opposing surfaces of wafers or sheets as illustrated in Figures 2A-2C may be etched by depositing copper on each surface followed by etching of each surface. If more than one surface is to be etched then copper deposition and etching may be carried out on a first surface to be etched, and the one or more further surfaces to be etched may be treated likewise in sequence. Alternatively, one or both of copper deposition and etching may occur simultaneously at more than one surface. For example, simultaneous etching may take place by arranging a substrate carrying copper on more than one surface such that the two or more of the surfaces carrying copper are exposed to the etching composition.

In an embodiment, a starting substrate having a silicon surface, such as a silicon wafer or sheet, may be broken into a plurality of smaller silicon structures before or after etching. In this embodiment, the starting silicon wafer or sheet is preferably thin, e.g. a silicon wafer having a thickness of around 10 to 50 µm. Preferably, the starting substrate is broken gently in order to minimise disturbance and / or damage to the crystalline structure and crystal orientation of the wafer. The starting silicon structure may be broken into particles having an average length of no more than about 500 microns. Average lengths may be determined by taking an SEM image of one or more samples of the broken wafer particles and measuring lengths of particles shown in the image or images.

Figures 2A - 2C illustrate a process of etching a silicon wafer or sheet, however it will be appreciated that the same process may be applied to etching of silicon particles, as described in more detail below, in order to form pores and / or pillars on the surface of the silicon particles.

Pillars may be formed by etching the silicon surface to a depth of more than 0.5 microns, optionally at least 1 micron, optionally at least 2 microns, optionally no more than 10 microns. Optionally, the pillars are formed by etching the silicon surface to a depth in the range of 2-10 microns.

The pillars may have a diameter or thickness in the range of about 0.02 to 0.70 µm, e.g. 0.1 to 0.5µm, for example 0.1 to 0.25µm, preferably in the range 0.04 to 0.50µm. The pillars may have an aspect ratio (defined as the height of the pillar divided by the average thickness or diameter of the pillar at its base) in the range 5:1 to 100:1, preferably in the range 10:1 to 100:1. The pillars may be substantially circular in cross-section but they need not be. Where the pillars have irregular cross-sections comprising a plurality of extended sections with changing direction and/or with branches or spurs then the average thickness of the plurality of such section is used in the calculation of the aspect ratio. The pillars may extend outwards from the silicon in any direction and may comprise kinks or changes in direction along their length.

The surfaces of pores or pillars may be relatively smooth or they may be rough. The surfaces may be pitted or comprise pores or voids with diameters less than 50nm. The pillar structures may be mesoporous or microporous.

The porosity of the etched silicon may be defined as the percentage ratio of the total volume of the void space or pores introduced into the etched silicon to the volume of the silicon before etching. A higher porosity may provide a higher surface area which may increase the reactivity of the silicon in a device, for example in electrochemical cells, sensors, detectors, filters etc. or it may provide a larger volume for containing ingredients or active agents in medical or consumer product compositions. However, if the porosity is too large the structural integrity (or mechanical strength) of the silicon may be reduced and for example, in devices such as a lithium ion battery, the volume of electrochemically active silicon material is reduced. The porosity of the etched silicon may be at least 5%, optionally at least 10%. Preferably it is at least 20%. The porosity may be less than 90%, optionally less than 80%. Preferably it is no more than 75%.

Dimensions of pores and pillars may be measured using optical methods, for example scanning electron microscopy. Porosity may be measured using known gas or mercury porosimetry techniques or by measuring the mass of the silicon material before and after etching.

Without wishing to be bound by any theory, it is believed that electroless formation of elemental copper includes a first stage during which copper islands are formed that then may extend laterally and join together to form a copper layer. This copper layer may be a monolayer formed by joining together of multiple copper monolayer islands. Further copper deposition results in uniform thickness growth of the copper layer. This is in contrast to electroless formation of silver, which is believed to form clumps of silver interconnected by dendrites, each clump having a thickness of multiple silver atoms.

It will be appreciated that etching of islands of copper as illustrated in Figures 2A and 2B allows formation of pores or pillars. Furthermore, and again without wishing to be bound by any theory, it is believed that a monolayer of copper formed by joining of copper islands will not cover 100% of an underlying silicon surface because packing of an electrolessly formed monolayer of copper, for example by hexagonal packing, and that etching with such a monolayer may still produce a pattern of pores or pillars in the silicon surface.

However, and again without wishing to be bound by any theory, once the copper layer thickness exceeds a monolayer or once the copper layer otherwise covers substantially all of the silicon surface, it is believed that gases generated during etching may have no path for escape from the silicon, resulting in these gases pressing against the underside of the copper layer which in turn may result in poor etching of the silicon. Furthermore, in this case HF and oxidant contained within the etching solution may be blocked by the copper layer from reaching the silicon surface.

However the coverage of the silicon surface by copper must be sufficient enough to achieve the desired porosity or pillar density and dimensions. Preferably at least 10% of the silicon surface to be etched should be covered by the copper layer, optionally at least 20%, at least 50 % or at least 75 %. Copper surface coverage may be less than 99 % or less than 95 %. Copper surface coverage may be measured using optical methods, for example scanning electron microscopy or other known analytical techniques such as electron back-scattered diffractometry or energy dispersive x-ray spectrometry.

Accordingly, in one embodiment, the copper metal formed on the surface of the silicon during the inventive process is in the form of a monolayer and / or in the form of a plurality of isolated islands of copper.

Following formation of the etched silicon structure, residual copper in the etched silicon structure and / or on the surface of the etched silicon structure may be washed out or chemically removed. Alternatively, the residual copper may be retained, for example to improve conductivity of the silicon. The etched silicon structure containing residual copper may be annealed to form copper silicide, which may improve copper-silicon adhesion.

### Silicon

The one or more silicon surfaces of a substrate to be etched may be undoped, n-doped, p-doped or a mixture thereof. Preferably, the silicon is n- or p-doped. Examples of p-type dopants for silicon include B, Al, In, Mg, Zn, Cd and Hg. Examples of n-type dopants for silicon include P, As, Sb and C. Dopants such as germanium and silver can also be used.

The silicon substrate may be a material having silicon at one or more surfaces thereof and a non-silicon core. Examples include particles having a non-silicon (e.g. graphite) core and silicon shell, and a sheet having a non-silicon core sandwiched by silicon layers.

The silicon to be etched may be supported on a surface of another material.

The silicon may be pure silicon or may be an alloy or other mixture of silicon and one or more other materials. The silicon may have a purity of at least 90.00 wt%, optionally at least 99 wt%. Optionally the silicon purity may be less than 99.9999 wt%. The silicon may be metallurgical grade silicon.

The silicon may have a resistivity of at least 0.005 Ω.cm, optionally at least 0.01 Ω.cm, optionally at least 1Ω.cm. The silicon resistivity may be up to about 100 Ω.cm.

The silicon surface of the substrate is optionally selected from (100) and (111) silicon, or a silicon surface that is symmetrically equivalent to (100) or (111) silicon, denoted hereinafter as {100} and {111} silicon respectively. It will be understood that {100} silicon includes the symmetrically equivalent group of planes (100) (010) and (001).

It will be understood that the substrate may include one or more {100} or {111} silicon surfaces and one or more silicon surfaces other than {100} or {111} silicon. For example, flakes of silicon may have at least one (100) or (111) surface and one or more other silicon surfaces.

Etching may be carried out on, for example, bulk silicon or on a silicon powder. Exemplary bulk silicon structures include silicon sheets such as silicon wafers or of metallurgical grade silicon, and silicon sheets or chips formed by breaking a silicon wafer into smaller pieces, or by breaking other forms of bulk silicon into sheets or flakes. Powder particles of silicon may be formed from a silicon source such as metallurgical grade silicon by any process known to the skilled person, for example by grinding or jetmilling bulk silicon to a desired size. Suitable example silicon powders are available as "Silgrain™" from Elkem of Norway.

Where used, bulk silicon such as a silicon wafer may have first and second opposing surfaces, each surface having an area of at least 0.25 cm², optionally at least 0.5 cm², optionally at least 1 cm². Each surface may be substantially planar. Bulk silicon may have a thickness of more than 0.5 micron, optionally more than 1 micron, optionally more than 10 microns, optionally more than 100 microns, optionally in the range of about 100 - 1000 microns.

Where used, particles may be in the form of flakes or wires, or cuboid, substantially spherical or spheroid particles. They may be multifaceted or may have substantially continuous curved surfaces. Non-spherical core particles may have an aspect ratio of at least 1.5 : 1, optionally at least 2 : 1. Silicon flakes preferably have an aspect ratio of at least 2 : 1.

The particles may have a size with a largest dimension up to about 100µm, preferably less than 50µm, more preferably less than 30µm.

The particles may have at least one smallest dimension less than one micron. Preferably the smallest dimension is at least 0.5 microns.

Particle sizes may be measured using optical methods, for example scanning electron microscopy.

In a composition containing a plurality of particles, for example a powder, preferably at least 20%, more preferably at least 50% of the particles have smallest dimensions in the ranges described above. Particle size distribution may be measured using laser diffraction methods or optical digital imaging methods.

### Battery formation

Etched silicon formed as described herein may be used to form the anode of a rechargeable metal ion battery. The battery may be as described with reference to Figure 1.

In the case where bulk silicon is etched, an anode current collector may be formed on one side of the bulk silicon and another side of the bulk silicon having an etched surface may come into contact with the electrolyte of the battery. The current collector may be a metal foil, for example copper, nickel or aluminium, or a non-metallic current collector such as carbon paper

The present inventors have found that etching may be carried out with a relatively small quantity of copper ions as compared to a corresponding process using silver ions. Accordingly, in one embodiment etched bulk silicon, such as a silicon wafer, may be used to form the anode of a metal ion battery without first washing or otherwise treating the bulk silicon to remove residual metal in the wafer. Residual copper present in the wafer may serve to increase conductivity of the anode. Etched silicon containing copper may be annealed to form copper silicide at the copper-silicon interface to improve adhesion of the copper to the silicon.

In the case where the silicon is in particulate forma slurry comprising the particulate silicon and one or more solvents may be deposited over an anode current collector to form an anode layer. The silicon particles may be one or more of etched silicon particles formed by etching a particulate starting material or by fracturing a larger starting material; porous silicon fragments detached from an etched porous silicon surface; and discrete silicon fibres or clumps of silicon fibres formed by detaching silicon pillars from an etched silicon surface. Silicon particles may be provided as a powder of the particles. The slurry may further comprise a binder material, for example polyimide, polyacrylic acid (PAA) and alkali metal salts thereof, polyvinylalchol (PVA) and polyvinylidene fluoride (PVDF), sodium carboxymethylcellulose (Na-CMC) and optionally, non-active conductive additives, for example carbon black, carbon fibres, ketjen black or carbon nanotubes. In addition to providing the silicon particles to act as an active material in the battery, one or more further active materials may also be provided in the slurry. Exemplary further active materials include active forms of carbon such as graphite or graphene,. Active graphite may provide for a larger number of charge / discharge cycles without significant loss of capacity than active silicon, whereas silicon may provide for a higher capacity than graphite. Accordingly, an electrode composition comprising a silicon-containing active material and a graphite active material may provide a lithium ion battery with the advantages of both high capacity and a large number of charge / discharge cycles. The slurry may be deposited on a current collector, which may be as described above. Further treatments may be done as required, for example to directly bond the silicon particles to each other and/or to the current collector. Binder material or other coatings may also be applied to the surface of the composite electrode layer after initial formation.

Examples of suitable cathode materials include LiCoO₂, LiCo_{0.99}Al_{0.01}O₂, LiNiO₂, LiMnO₂, LiCo_{0.5}Ni_{0.5}O₂, LiCo_{0.7}Ni_{0.3}O₂, LiCo_{0.8}Ni_{0.2}O₂, LiCo_{0.82}Ni_{0.18}O₂, LiCo_{0.8}Ni_{0.15}Al_{0.05}O₂, LiNi_{0.4}Co_{0.3}Mn_{0.3}O₂ and LiNi_{0.33}Co_{0.33}Mn_{0.34}O₂. The cathode current collector is generally of a thickness of between 3 to 500µm. Examples of materials that can be used as the cathode current collector include aluminium, stainless steel, nickel, titanium and sintered carbon.

The electrolyte is suitably a non-aqueous electrolyte containing a lithium salt and may include, without limitation, non-aqueous electrolytic solutions, solid electrolytes and inorganic solid electrolytes. Examples of non-aqueous electrolyte solutions that can be used include non-protic organic solvents such as propylene carbonate, ethylene carbonate, butylenes carbonate, dimethyl carbonate, diethyl carbonate, gamma butyro lactone, 1,2-dimethoxy ethane, 2-methyl tetrahydrofuran, dimethylsulphoxide, 1,3-dioxolane, formamide, dimethylformamide, acetonitrile, nitromethane, methylformate, methyl acetate, phosphoric acid trimester, trimethoxy methane, sulpholane, methyl sulpholane and 1,3-dimethyl-2-imidazolidione.

Examples of organic solid electrolytes include polyethylene derivatives polyethyleneoxide derivatives, polypropylene oxide derivatives, phosphoric acid ester polymers, polyester sulphide, polyvinyl alcohols, polyvinylidine fluoride and polymers containing ionic dissociation groups.

Examples of inorganic solid electrolytes include nitrides, halides and sulphides of lithium salts such as Li₅NI₂, Li₃N, LiI, LiSiO₄, Li₂SiS₃, Li₄SiO₄, LiOH and Li₃PO₄.

The lithium salt is suitably soluble in the chosen solvent or mixture of solvents. Examples of suitable lithium salts include LiCl, LiBr, LiI, LiClO₄, LiBF₄, LiBC₄O₈, LiPF₆, LiCF₃SO₃, LiAsF₆, LiSbF₆, LiAlCl₄, CH₃SO₃Li and CF₃SO₃Li.

Where the electrolyte is a non-aqueous organic solution, the battery is provided with a separator interposed between the anode and the cathode. The separator is typically formed of an insulating material having high ion permeability and high mechanical strength. The separator typically has a pore diameter of between 0.01 and 100µm and a thickness of between 5 and 300µm. Examples of suitable electrode separators include a micro-porous polyethylene film.

Etched silicon structures comprising pores or elongated pillar-like structures, porous silicon fragments or detached silicon fibres as described herein may be used in a wide range of applications in addition to rechargeable metal ion batteries including, without limitation, electrochemical cells, lithium air batteries, flow cell batteries, other energy storage devices such as fuel cells, thermal batteries, photovoltaic devices such as solar cells, filters, sensors, electrical and thermal capacitors, microfluidic devices, gas/vapour sensors, thermal or dielectric insulating devices, devices for controlling or modifying the transmission, absorption or reflectance of light or other forms of electromagnetic radiation, chromatography or wound dressings.

Porous silicon particles may also be used for the storage, controlled delivery or timed release of ingredients or active agents in consumer care products including oral hygiene and cosmetic products, food or other nutritional products, or medical products including pharmaceutical products that deliver drugs internally or externally to humans or animals.

Etched silicon may also form architectured conducting or semiconducting components of electronic circuitry.

### Examples

### General procedure

In a first stage, a n-doped silicon wafer (about 1 cm²) having (100) orientation and having a resistivity in the range of about 1-10 Ω.cm was placed in 50ml of a first solution of HF and either CuSO₄ or Cu(NO₃)₂. Copper is allowed to form on the surface of the silicon wafer for a first period of time, after which the silicon wafer carrying copper is gently rinsed with deionised water.

In a second stage, the silicon wafer was then placed in a second solution of HF and NH₄NO₃ for at least 30 minutes to form etched silicon.

In an optional third step, the etched silicon wafer was washed with water.

The surface of only one side of a silicon wafer is etched in this general procedure, however it will be appreciated that surfaces on both sides of a silicon wafer may be etched by carrying out the general procedure on both sides of the wafer. Each of the copper deposition and etching steps may be carried out on one surface at a time, or on both surfaces simultaneously.

### Examples 1-5

In the first stage, a silicon wafer was placed in a first solution of 20mM CuSO₄ +7M HF, and in the second stage the wafer was placed in a second solution of 0.2M NH₄NO₃ +7M HF for 3 hours. Both stages were carried out at room temperature.

The wafer was kept in the first solution for the periods of time shown in Table 1 below.

**Table 1**

| **Example** | **Time in first solution (seconds)** | **Figures** |
|---|---|---|
| 1 | 10 | 3 |
| 2 | 20 | 4A and 4B |
| 3 | 60 | 5A and 5B |
| 4 | 90 | 6A and 6B |
| 5 | 120 | 7A and 7B |

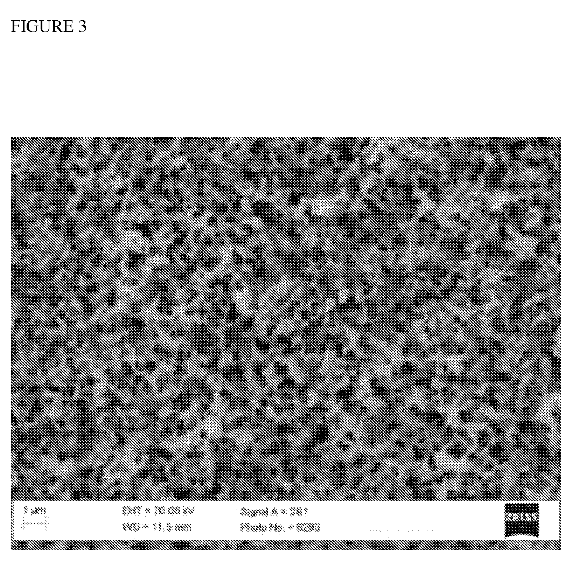

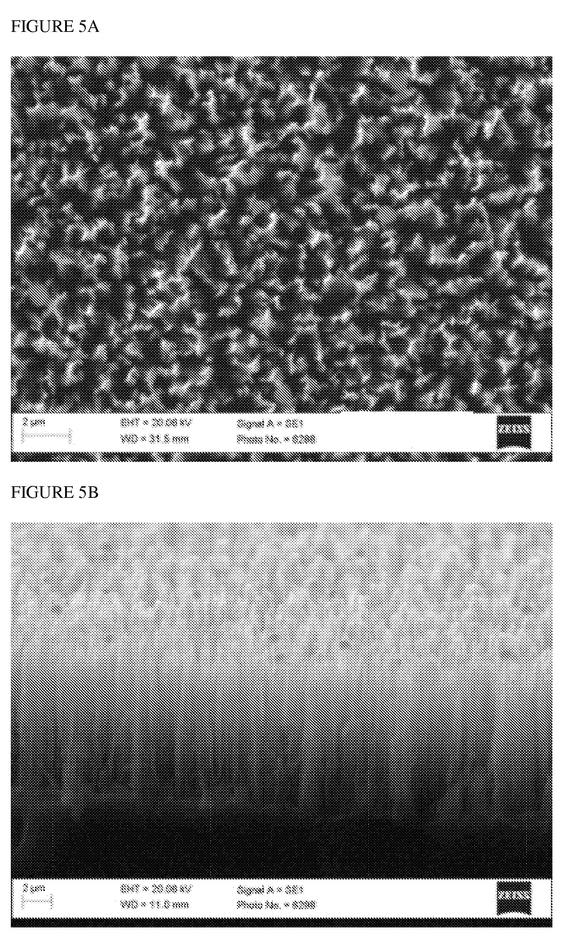

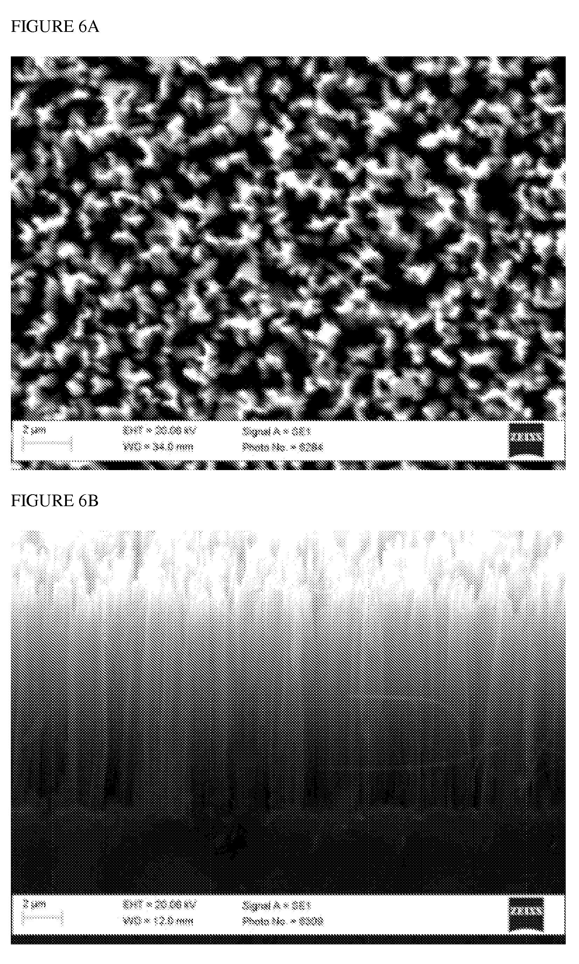

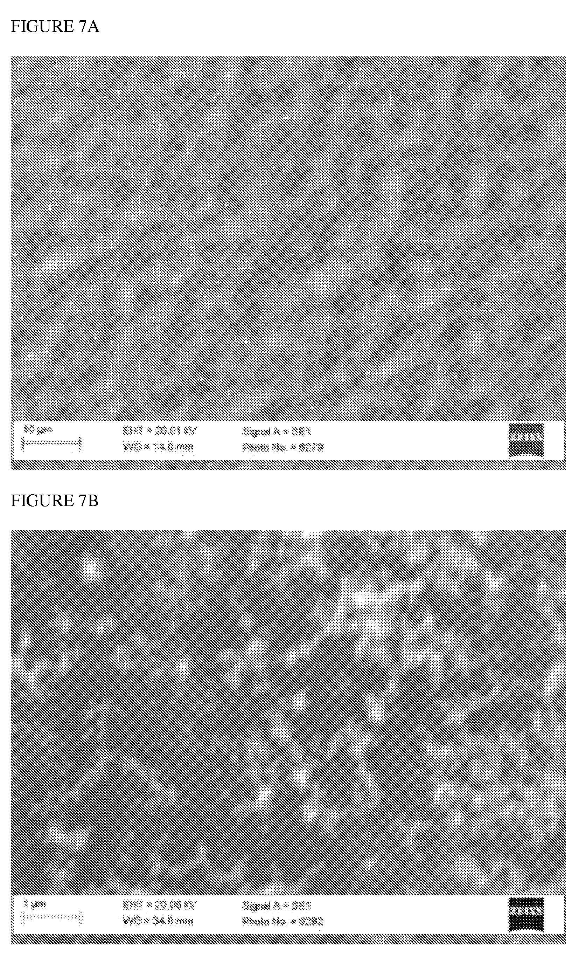

With reference to Figures 3-7, it can be seen that the density and / or length of pillars is generally greater at shorter times in the first solution.

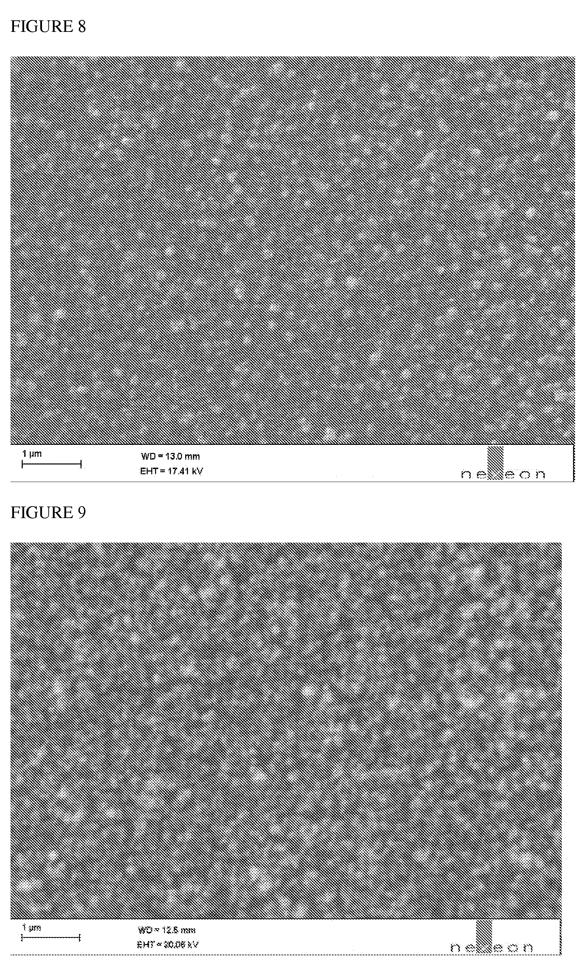

Without wishing to be bound by any theory, it is believed that this is due to formation of a uniform copper film of more than monolayer thickness at longer times in the first solution, which results in substantially isotropic etching of the underlying silicon, and / or prevents escape of gases (in particular hydrogen) generated during the etching process. This can be seen in Figures 8 and 9, which illustrate the surface of silicon after 20 seconds and after 120 seconds in the first solution respectively. Figure 8 shows a plurality of isolated islands of copper formed on the surface of the silicon wafer, whereas Figure 9 shows a substantially uniform film of copper on the surface of the silicon wafer.

Accordingly, in one embodiment it is preferred that the silicon is exposed to the first solution for a relatively short period of time, and that the second solution is substantially free of copper. In this example, the second solution comprises ammonium nitrate, however it will be appreciated that other water-soluble nitrates may be used, in particular metal nitrates other than copper nitrate.

Example 2 was repeated except that 10 wt% methanol was included in the second solution. The extent of etching was found to be considerably reduced as compared to Example 2, producing silicon with a small number of shallow pores.

### Example 6

A silicon wafer was treated as described in Example 2, except that the second stage was conducted at a temperature of 60 - 70°C.

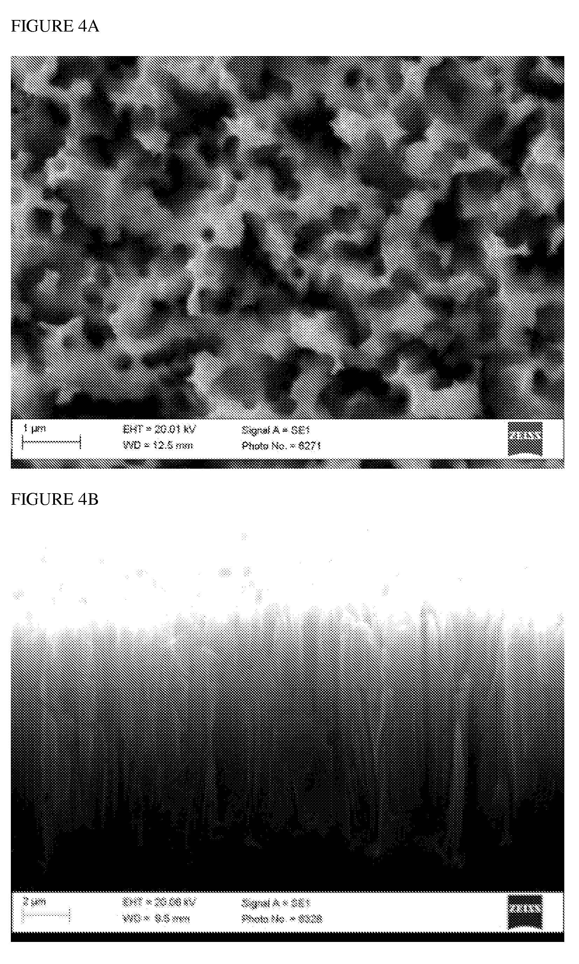

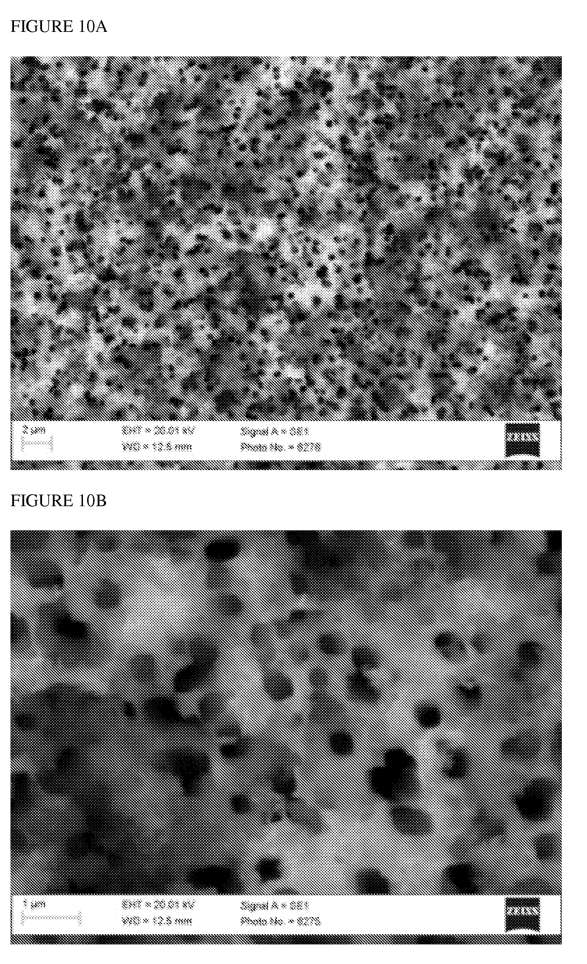

With reference to Figure 10A and the magnified image of Figure 10B, the extent of etching is lower than that of Example 2 (Figures 4A and 4B), illustrating that the extent of etching may be controlled, at least in part, by the etching temperature.

### Examples 7 and 8

A silicon wafer was treated as described in Example 2, except that the concentration of NH₄NO₃ was 0.4 M in Example 7, and 0.6 M in Example 8.

No significant difference was observed in the etched silicon produced in Examples 2, 7 and 8.

### Examples 9-12

A silicon wafer was treated according to the general method wherein in the first stage a silicon wafer was placed in a solution of 20mM CuSO₄ +7M HF for 30 seconds, and in the second stage the wafer was placed in a solution of 0.2M NH₄NO₃ +7M HF for 1.5 hours. Both stages were carried out at room temperature.

The resistivity and doping of the wafer was varied as illustrated in Table 2 below.

**Table 2**

| **Example** | **Si doping** | **Si resistivity (Ω.cm)** | **Figures** |
|---|---|---|---|
| 9 | n-doped | 0.01∼0.03 Ω.cm | 11A and 11B |
| 10 | n-doped | 0.08∼0.1 Ω.cm | 12A and 12B |
| 11 | n-doped | 1∼10 Ω.cm | 13A and 13B |
| 12 | p-doped | 1∼10 Ω.cm | 14A and 14B |

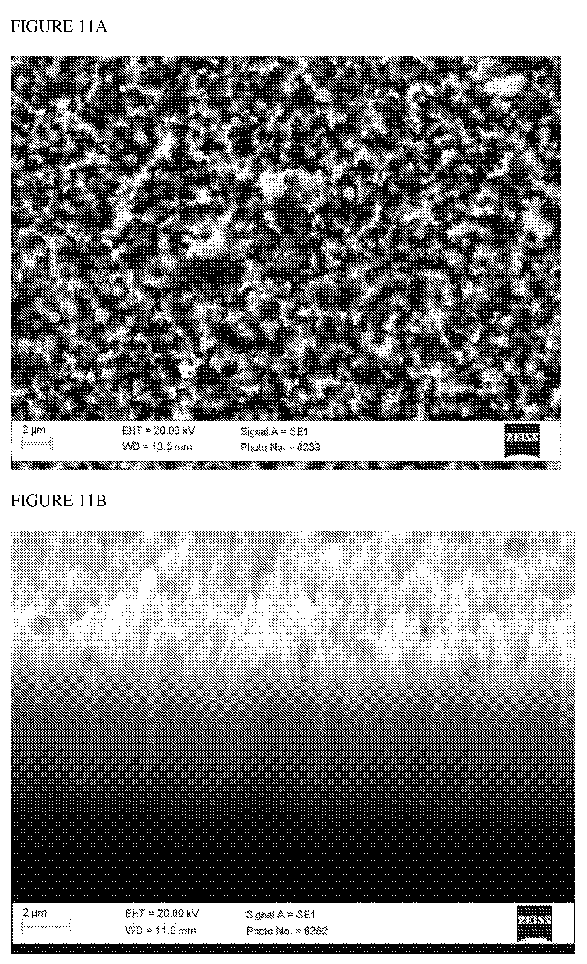

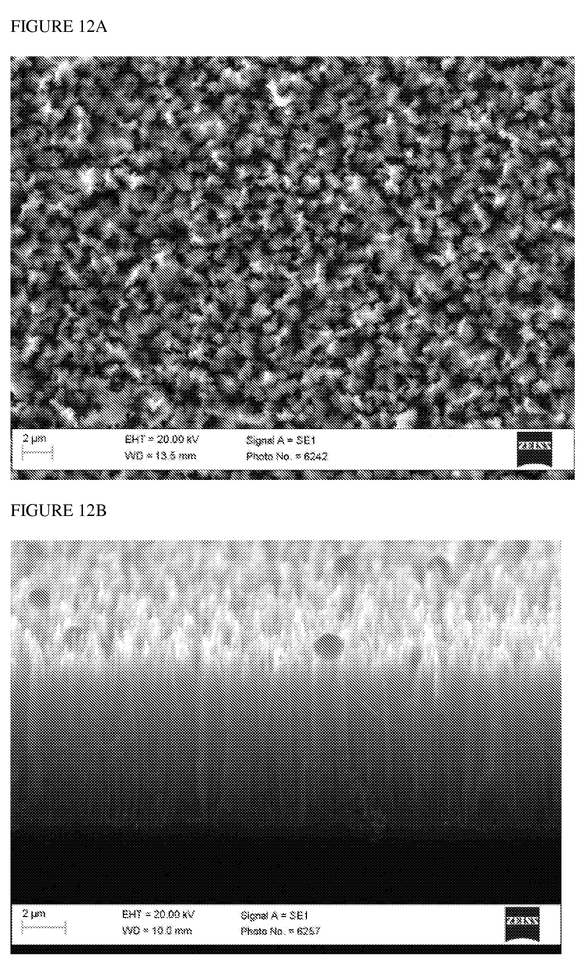

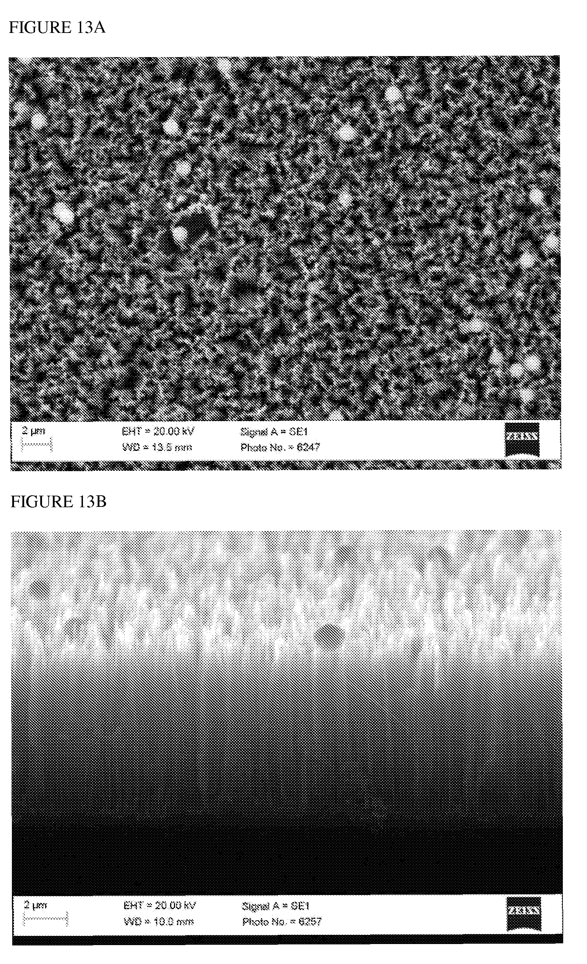

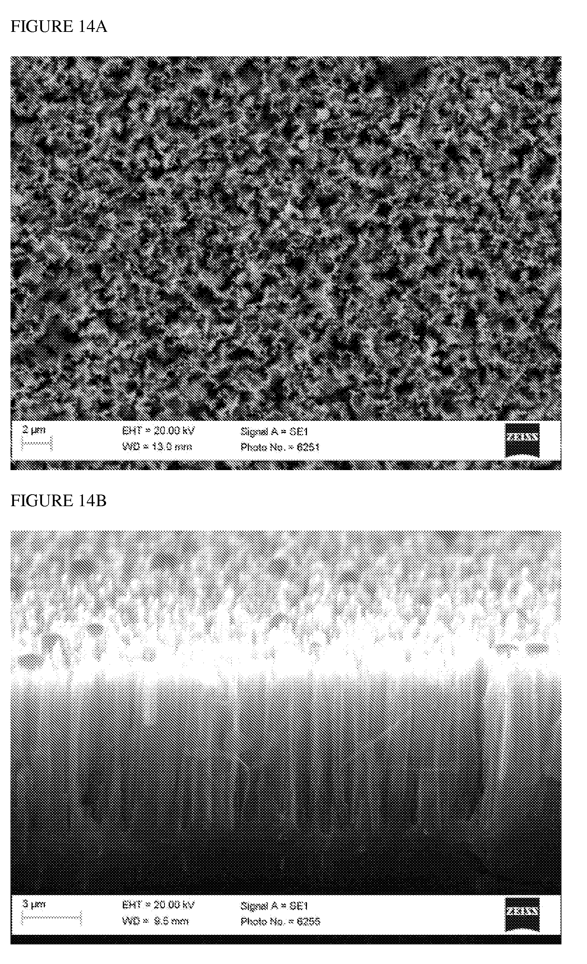

Pillars were formed in all cases, as shown in Figures 11 - 14. However, at lower resistivities, in particular up to about 0.001 Ω.cm, it was found that etching tended to be more isotropic.

### Example 13

A silicon wafer was treated according to the general method, except that silicon having the (110) orientation was etched.

In the first stage the silicon wafer was placed in a solution of 20mM CuSO₄ +7M HF for 20 seconds, and in the second stage the wafer was placed in a solution of 0.2M NH₄NO₃ +7M HF for 1.5 hours.

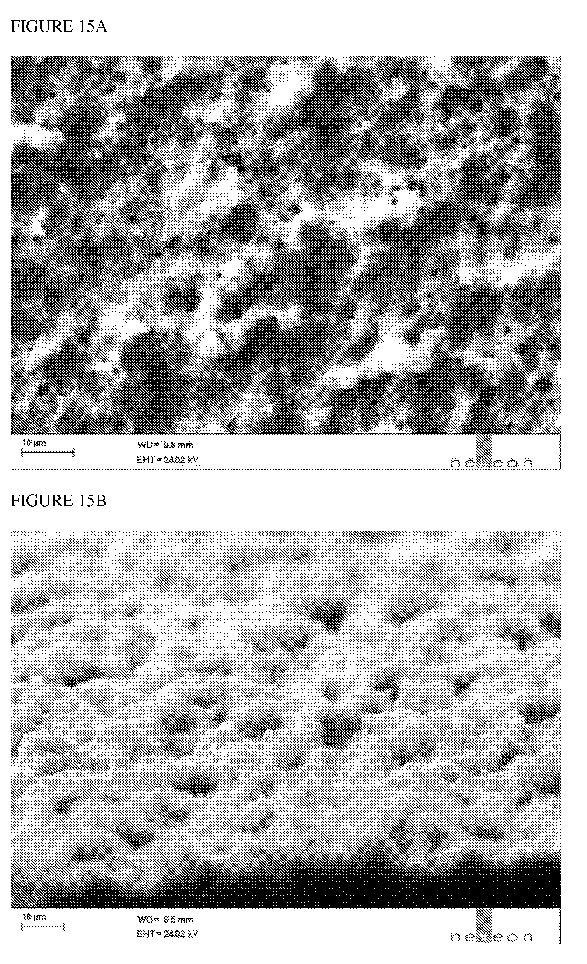

The etching process produced pores rather than pillars in the silicon, as shown in Figures 15A and 15B, in contrast to the pillars formed in the analogous process using silicon wafers having the (100) orientation, as described with reference to Examples 1-5.

### Example 14

A silicon wafer was treated according to the general method, except that silicon having the (110) orientation was used, and the silicon was cleaved. The cleaved edge has a (111) plane.

In the first stage the cleaved silicon wafer was placed in a solution of 0.2M CuSO₄ +7M HF for 30 seconds, and in the second stage the wafer was placed in a solution of 0.2M NH₄NO₃ +7M HF for 1.5 hours.

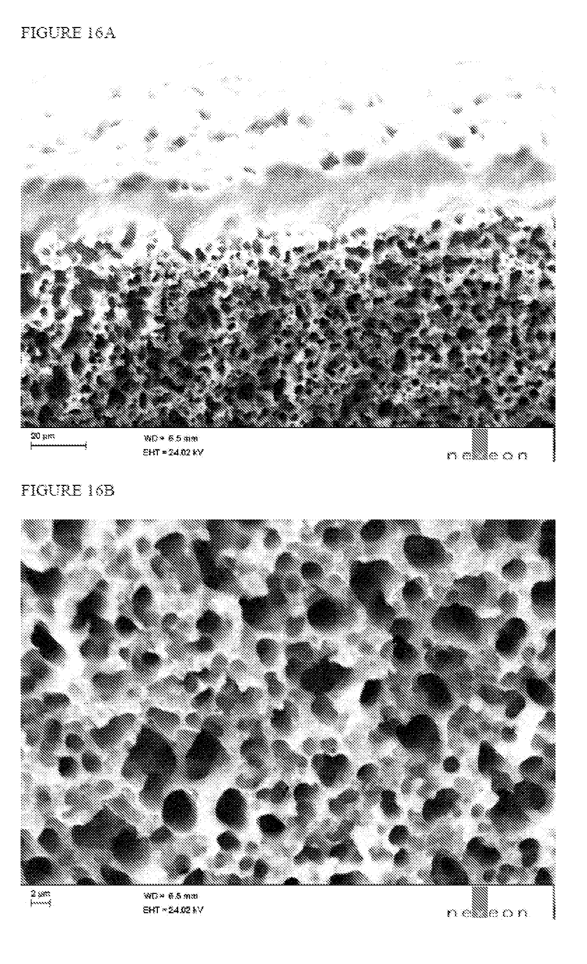

Figure 16A shows the (110) surface on top of the cleaved wafer, and the (111) surface is below. A clear difference can be seen in etching of the (111) and (110) surfaces, with deeper etching of the (111) surface.

Figure 16B is a magnification of the etched (111) surface of Figure 16A.

### Example 15

A silicon wafer was treated according to the general method, except that silicon having a (111) orientation was used, and the resistivity of the wafer was in the range of about 0.0008 - 0.001 Ω.cm.

In the first stage the cleaved silicon wafer was placed in a solution of 20mM CuSO₄ +7M HF for 30 seconds, and in the second stage the wafer was placed in a solution of 0.2M NH₄NO₃ +7M HF for 1.5 hours.

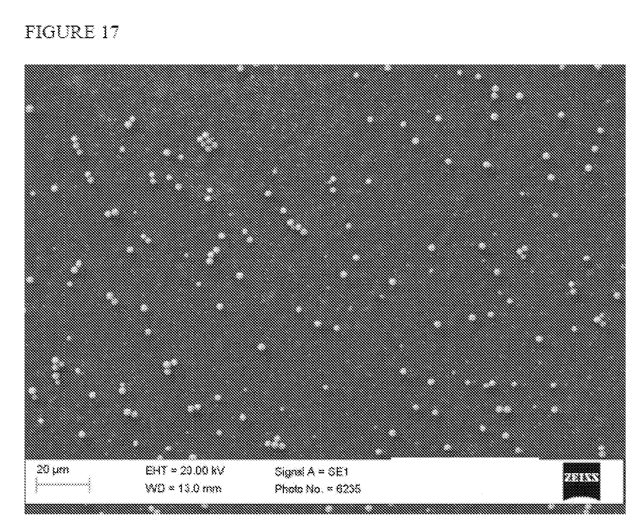

With reference to Figure 17, it can be seen that the degree of anisotropic etching is less at this low resistivity than etching of (111) silicon at a higher resistivity, as shown in Figures 16A and 16B. White spots present in Figure 17 may be an etching by-product.

### Example 16

The silicon wafer in this example was a thin (100) n-doped (boron) silicon wafer with a thickness of around 20 µm and having a resistivity of 1-20 Ohm-cm.

The silicon wafer is treated according to the general method wherein in the first stage a silicon wafer was placed in a solution of 20mM CuSO₄ + 7M HF for 30 seconds, and in the second stage the wafer was placed in a solution of 0.2mM NH₄NO₃ + 7M HF for 30 minutes.

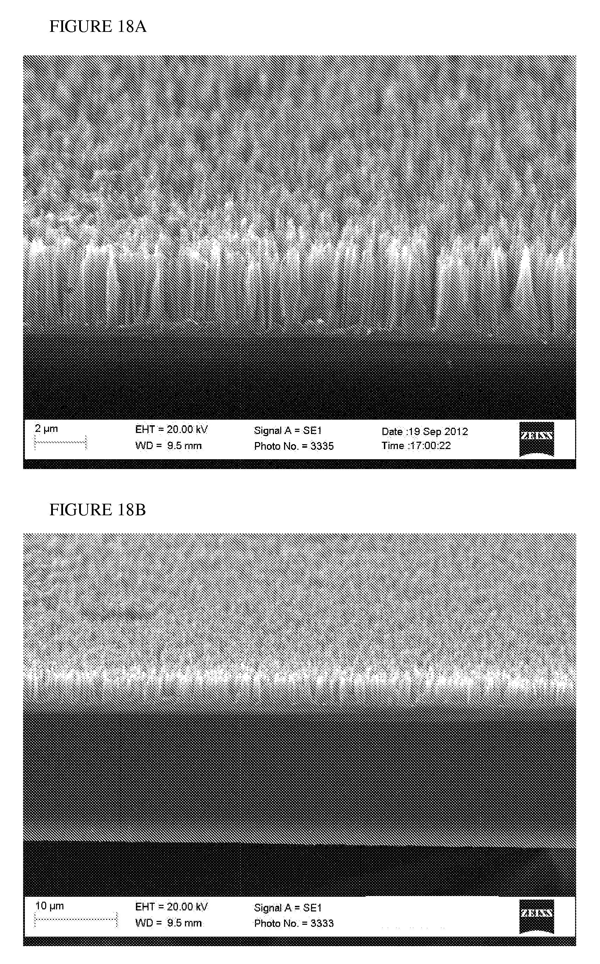

With reference to Figure 18A and magnified image 18B, pillars were formed to a height of 2µm.

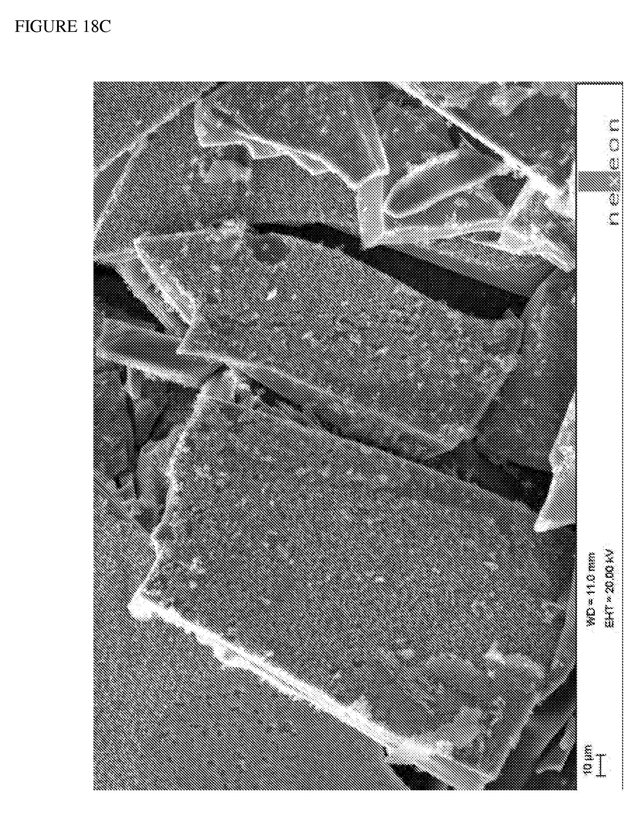

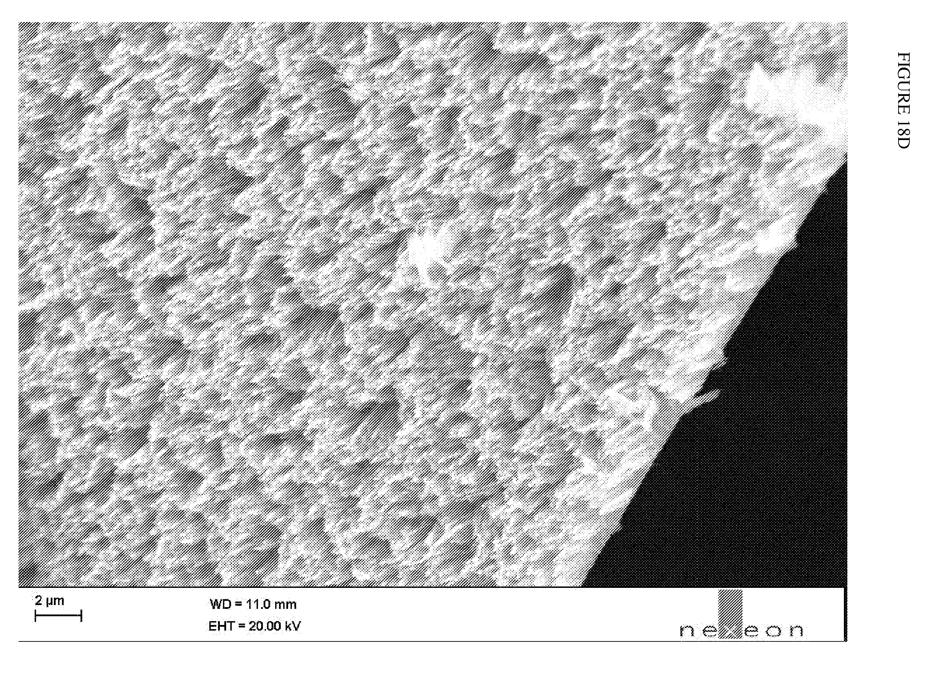

The etched wafer was then broken by gentle application of pressure to produce etched fragments as illustrated in Figure 18C. A magnified image of a fragment formed by fragmentation of the wafer is shown in Figure 18D, showing pillars extending from the wafer fragment.

The silicon wafer of this example was etched on one surface only, however it will be appreciated that the etching process could have been repeated on the surface opposing the etched surface in order to form a silicon wafer having

### Example 17

The silicon wafer in this example p-type, (100), 1∼100 Ω.cm silicon wafer with a thickness of around 200 µm.

The silicon wafer is treated according to the general method, wherein in the first stage a silicon wafer was placed in a solution of 20mM CuSO₄ + 7M HF for 30 seconds, and in the second stage the wafer was placed in a solution of 0.2M NH₄NO₃ + 7M HF for 30 minutes.

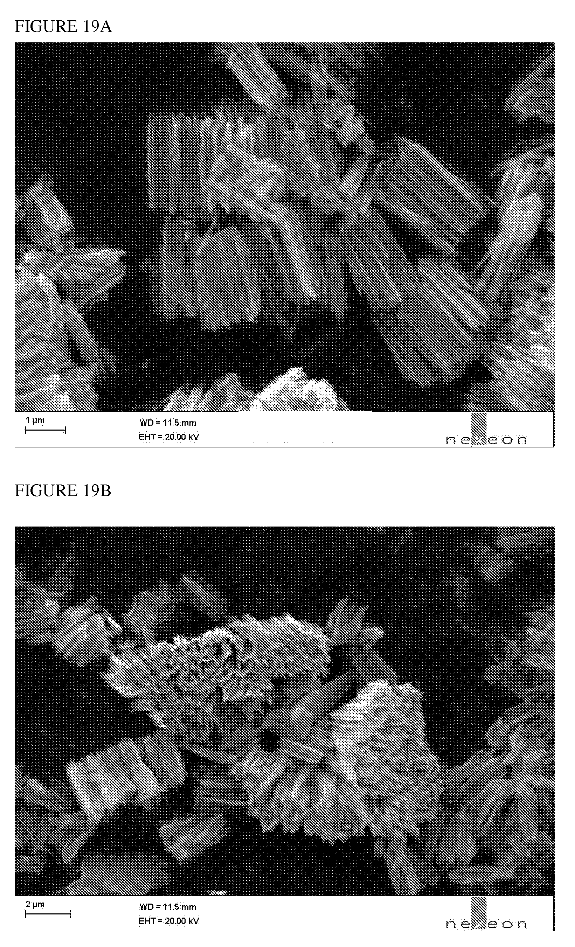

The pillars of the etched silicon wafer were then scraped off with a razor blade to provide discrete silicon fibres and clumps of fibres as illustrated by Figures 19A and 19B.

### Example 18

1g of silicon powder available from Elkem having a diameter in the range of 200 - 800 microns and a purity of 99.8% was treated as described with reference to Example 2.

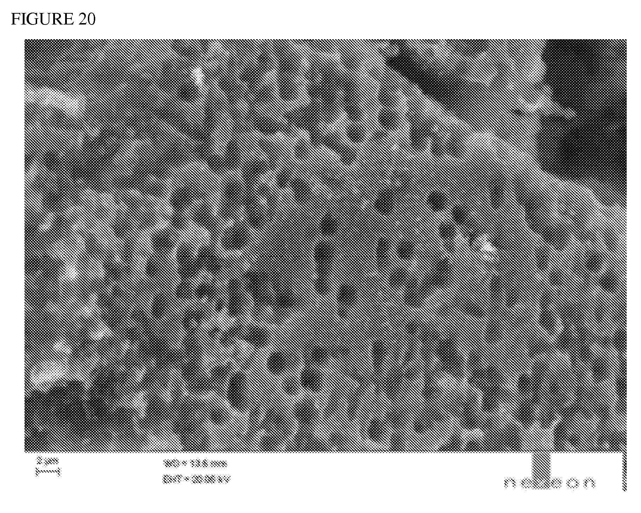

Figure 20 illustrates pores formed on the surface of the silicon powder.

The etched silicon as described herein may be used to form the anode of a rechargeable metal ion battery.

The invention has been described with reference to anodes of rechargeable batteries that operate by absorption and desorption of lithium ions, however it will be appreciated that etched silicon structures as described herein may be applicable to other metal ion batteries, for example sodium or magnesium ion batteries. Moreover, it will be appreciated that etched silicon as described herein may be used in devices other than metal ion batteries, for example filters, other energy storage devices such as fuel cells, photovoltaic devices such as solar cells, sensors, and capacitors. Etched silicon as described herein may also form conducting or semiconducting components of electronic circuitry.

Although the present invention has been described in terms of specific exemplary embodiments, it will be appreciated that various modifications, alterations and/or combinations of features disclosed herein will be apparent to those skilled in the art without departing from the scope of the invention as set forth in the following claims.

## Claims

1. A method of etching silicon, the method comprising the steps of: partially covering at least one silicon surface of a material to be etched with a plurality of isolated islands of copper metal by an electroless deposition process comprising exposing the at least one surface of the material to be etched to an aqueous deposition composition comprising a copper salt and a source of fluoride ions; and exposing the at least one surface to an aqueous etching composition comprising an oxidant selected from the acid or salt of NO₃⁻ or NO₂⁻ and a source of fluoride ions wherein a bias is not applied to the silicon during etching of the material to be etched,
wherein the aqueous etching composition is formed by adding the oxidant and, optionally, further fluoride ions to the aqueous deposition composition in aqueous form, and wherein the concentration of copper ions is diluted by addition of the aqueous oxidant and optional further fluoride to substantially stop further electroless deposition of copper once the electrolessly deposited copper has formed the plurality of isolated islands of copper; or
wherein the material to be etched is removed from the aqueous deposition composition following formation of the plurality of isolated islands of copper metal and before being exposed to the aqueous etching composition.

2. A method according to claim 1 wherein the oxidant is selected from the group consisting of alkali metal nitrates, ammonium nitrate and mixtures thereof.

3. A method according to claim 1 wherein the isolated islands have a diameter in the range of 50-200 nm, optionally 50-100 nm.

4. A method according to any preceding claim wherein the at least one surface is etched to form silicon pillars extending from an etched silicon surface formed by etching of the at least one surface, the method optionally comprising the further step of detaching the silicon pillars from the etched silicon surface.

5. A method according to any preceding claim wherein the aqueous etching composition is substantially free of alcohols.

6. A method according to any preceding claim wherein the silicon has a resistivity of at least 0.005 Ω.cm, optionally at least 0.01 Ω.cm.

7. A method according to any preceding claim, wherein the silicon is n-doped, p-doped or a mixture thereof.

8. A method according to any preceding claim wherein the at least one surface to be etched has a {111} or {100} orientation.

9. A method according to any preceding claim wherein the at least one surface of the material to be etched is etched to a depth of at least 0.5 microns.

10. A method according to any preceding claim wherein the etched silicon comprises pores extending into at least one etched surface formed by etching the at least one surface, optionally wherein the pores have a diameter of at least 50 nm.

11. A method according to any preceding claim wherein the material to be etched is in the form of bulk silicon, optionally a silicon wafer.

12. A method according to claim 11 comprising the step of breaking the etched bulk silicon into a plurality of etched bulk silicon fragments, optionally wherein the plurality of etched bulk silicon fragments form a powder.

13. A method according to any of claims 1-10 wherein the material to be etched is in the form of a silicon powder, wherein the silicon powder optionally comprises silicon flakes.

14. A method according to any preceding claim wherein residual copper on the surface of the etched silicon structure is retained.

15. A method according to claim 14 wherein the etched silicon structure is annealed to form copper silicide.

## Patentansprüche

1. Verfahren zum Ätzen von Silizium, wobei das Verfahren die folgenden Schritte umfasst: teilweises Bedecken mindestens einer Siliziumoberfläche von einem zu ätzenden Material mit einer Vielzahl von isolierten Kupfermetallinseln durch ein stromloses Abscheidungsverfahren, umfassend die Exposition der mindestens einen Oberfläche des zu ätzenden Materials gegenüber einer wässrigen Abscheidungszusammensetzung, umfassend ein Kupfersalz und eine Fluoridionenquelle; und Exposition der mindestens einen Oberfläche gegenüber einer wässrigen Ätzzusammensetzung, umfassend ein Oxidationsmittel, ausgewählt aus der Säure oder dem Salz von NO₃- oder NO₂- und einer Fluoridionenquelle, wobei während des Ätzens des zu ätzenden Materials keine Vorspannung an das Silizium angelegt wird,
wobei die wässrige Ätzzusammensetzung durch Zufügen des Oxidationsmittels und gegebenenfalls weiterer Fluoridionen zu der wässrigen Abscheidungszusammensetzung in wässriger Form gebildet wird, und wobei die Konzentration der Kupferionen durch Zufügen des wässrigen Oxidationsmittels und gegebenenfalls von weiterem Fluorid zum im Wesentlichen Stoppen einer weiteren stromlosen Abscheidung von Kupfer verdünnt wird, sobald das stromlos abgeschiedene Kupfer die Vielzahl isolierter Kupferinseln gebildet hat; oder
wobei das zu ätzende Material aus der wässrigen Abscheidungszusammensetzung nach Bildung der Vielzahl isolierter Kupfermetallinseln und vor der Exposition gegenüber der wässrigen Ätzzusammensetzung entfernt wird.

2. Verfahren nach Anspruch 1, wobei das Oxidationsmittel aus der Gruppe ausgewählt ist, bestehend aus Alkalimetallnitraten, Ammoniumnitrat und Gemischen davon.

3. Verfahren nach Anspruch 1, wobei die isolierten Inseln einen Durchmesser im Bereich von 50 bis 200 nm, gegebenenfalls 50 bis 100 nm aufweisen.

4. Verfahren nach einem der vorangehenden Ansprüche, wobei die mindestens eine Oberfläche zur Bildung von Siliziumsäulen, die sich von einer durch Ätzen der mindestens einen Oberfläche gebildeten geätzten Siliziumoberfläche erstrecken, geätzt wird, wobei das Verfahren gegebenenfalls den weiteren Schritt zum Loslösen der Siliziumsäulen von der geätzten Siliziumoberfläche umfasst.

5. Verfahren nach einem der vorangehenden Ansprüche, wobei die wässrige Ätzzusammensetzung im Wesentlichen frei von Alkoholen ist.

6. Verfahren nach einem der vorangehenden Ansprüche, wobei das Silizium eine Resistivität von mindestens 0,005 Ω.cm, gegebenenfalls mindestens 0,01 Ω.cm aufweist.

7. Verfahren nach einem der vorangehenden Ansprüche, wobei das Silizium n-dotiert, p-dotiert oder ein Gemisch davon ist.

8. Verfahren nach einem der vorangehenden Ansprüche, wobei die mindestens eine zu ätzende Oberfläche eine {111}-oder eine {100}-Orientierung aufweist.

9. Verfahren nach einem der vorangehenden Ansprüche, wobei die mindestens eine Oberfläche des zu ätzenden Materials bis zu einer Tiefe von mindestens 0,5 µm geätzt wird.

10. Verfahren nach einem der vorangehenden Ansprüche, wobei das geätzte Silizium Poren umfasst, die sich in mindestens eine geätzte Oberfläche erstrecken, die durch Ätzen der mindestens einen Oberfläche gebildet wird, gegebenenfalls, wobei die Poren einen Durchmesser von mindestens 50 nm aufweisen.

11. Verfahren nach einem der vorangehenden Ansprüche, wobei das zu ätzende Material in der Form von Bulk-Silizium, gegebenenfalls von einem Silizium-Wafer vorliegt.

12. Verfahren nach Anspruch 11, umfassend den Schritt des Zerbrechens des geätzten Bulk-Siliziums in eine Vielzahl geätzter Bulk-Siliziumfragmente, gegebenenfalls wobei die Vielzahl geätzter Bulk-Siliziumfragmente ein Pulver bildet.

13. Verfahren nach einem der Ansprüche 1 bis 10, wobei das zu ätzende Material in der Form eines Siliziumpulvers vorliegt, wobei das Siliziumpulver gegebenenfalls Siliziumflocken umfasst.

14. Verfahren nach einem der vorangehenden Ansprüche, wobei der restliche Kupfer auf der Oberfläche der geätzten Siliziumstruktur zurückgehalten wird.

15. Verfahren nach Anspruch 14, wobei die geätzte Siliziumstruktur zur Bildung von Kupfersilicid getempert wird.

## Revendications

1. Procédé de gravure de silicium, le procédé comprenant les étapes consistant à : recouvrir partiellement au moins une surface en silicium d'un matériau à graver avec une pluralité d'îlots isolés de cuivre métal par un processus de dépôt autocatalytique comprenant l'exposition de ladite au moins une surface du matériau à graver à une composition de dépôt aqueuse comprenant un sel de cuivre et une source d'ions fluorure ; et exposer ladite au moins une surface à une composition de gravure aqueuse comprenant un agent oxydant choisi parmi l'acide ou le sel de NO₃⁻ ou NO₂⁻ et une source d'ions fluorure, aucune polarisation n'étant appliquée au silicium pendant la gravure du matériau à graver,
dans lequel la composition de gravure aqueuse est formée en ajoutant l'agent oxydant et, facultativement, d'autres ions fluorure sous forme aqueuse à la composition de dépôt aqueuse, et dans lequel la concentration en ions de cuivre est diluée en ajoutant l'agent oxydant aqueux et un autre fluorure facultatif afin de stopper pratiquement un dépôt autocatalytique supplémentaire de cuivre une fois que le cuivre déposé par voie autocatalytique a formé la pluralité d'îlots de cuivre isolés ; ou
dans lequel le matériau à graver est enlevé de la composition de dépôt aqueuse après la formation de la pluralité d'îlots isolés de cuivre métal et avant son exposition à la composition de gravure aqueuse.

2. Procédé selon la revendication 1, dans lequel l'agent oxydant est choisi dans le groupe constitué par des nitrates de métaux alcalins, le nitrate d'ammonium et des mélanges de ces composés.

3. Procédé selon la revendication 1, dans lequel les îlots isolés ont un diamètre dans la plage de 50 à 200 nm, facultativement de 50 à 100 nm.

4. Procédé selon l'une quelconque des revendications précédentes, dans lequel ladite au moins une surface est gravée pour former des piliers en silicium qui s'étendent depuis une surface en silicium gravée formée par gravure de ladite au moins une surface, le procédé comprenant facultativement l'étape supplémentaire consistant à détacher les piliers en silicium de la surface en silicium gravée.

5. Procédé selon l'une quelconque des revendications précédentes, dans lequel la composition de gravure aqueuse est pratiquement dépourvue d'alcools.

6. Procédé selon l'une quelconque des revendications précédentes, dans lequel le silicium a une résistivité au moins égale à 0,005 Ω.cm, facultativement au moins égale à 0,01 Ω.cm.

7. Procédé selon l'une quelconque des revendications précédentes, dans lequel le silicium possède un dopage n, un dopage p ou un mélange de ceux-ci.

8. Procédé selon l'une quelconque des revendications précédentes, dans lequel ladite au moins une surface à graver a une orientation {111} ou {100}.

9. Procédé selon l'une quelconque des revendications précédentes, dans lequel ladite au moins une surface du matériau à graver est gravée à une profondeur d'au moins 0,5 microns.

10. Procédé selon l'une quelconque des revendications précédentes, dans lequel le silicium gravé comprend des pores qui s'étendent dans au moins une surface gravée formée par gravure de ladite au moins une surface, facultativement dans lequel les pores ont un diamètre d'au moins 50 nm.

11. Procédé selon l'une quelconque des revendications précédentes, dans lequel le matériau à graver se présente sous la forme de silicium massif, facultativement sous la forme d'une tranche de silicium.

12. Procédé selon la revendication 11, comprenant l'étape consistant à rompre le silicium massif gravé pour obtenir une pluralité de fragments de silicium massif gravé, facultativement dans lequel la pluralité de fragments de silicium massif gravé forme une poudre.

13. Procédé selon l'une quelconque des revendications 1 à 10, dans lequel le matériau à graver se présente sous la forme d'une poudre de silicium, la poudre de silicium comprenant facultativement des paillettes de silicium.

14. Procédé selon l'une quelconque des revendications précédentes, dans lequel le cuivre résiduel sur la surface de la structure en silicium gravée est conservé.

15. Procédé selon la revendication 14, dans lequel la structure en silicium gravée est recuite afin de former du siliciure de cuivre.
